# EUROPEAN PATENT SPECIFICATION

(11) **EP 1 173 902 B1**
(45) Date of publication and mention of the grant of the patent: **05.03.2003**
(21) Application number: 00925992.0
(22) Date of filing: 14.04.2000
(51) Int. Cl.: H01R 9/26

(54) **ELECTRICAL TERMINAL FOR AN INPUT-OUTPUT MODULE**
ELEKTRISCHER VERBINDER FÜR EIN EIN/AUSGABEMODUL
BORNE ELECTRIQUE POUR MODULE D'ENTREE-SORTIE

(30) Priority: 14.04.1999 US 129159 P
(43) Date of publication of application: 23.01.2002
(73) Proprietor: THE WHITAKER CORPORATION, Wilmington, Delaware 19808 (US)
(72) Inventor: LANDIS, John, M., Camp Hill, PA 17011 (US); FABIAN, David, J., Mt. Joy, PA 17552 (US)
(74) Representative: Jay, Anthony William
(86) International application number: US0010054
(87) International publication number: WO00062375

(56) References cited:
- EP-A- 0 877 542
- EP-A- 0 896 504
- DE-A- 19 826 390

## Description

This invention is related to electrical terminals and more particularly to electrical terminals that are used to interconnect adjacent modules in an input/output device.

It is well known in the art to use a plurality of electrical input/output modules that fit together in a stacked arrangement and are electrically connected together. It is also known that the modules may be mounted to a U-shaped metal rail that supports the device and provides electrical connection to ground.

U.S. Patent No. 5,775,955 discloses one such arrangement for a terminal block in which each module has plug-compatible male and female connectors that are electrically engaged by sliding a loose module along a rail and into engagement with modules that are fixed to the rail. To repair or replace a selected module in the stacked arrangement, it is necessary to slide and remove all the modules to one side of the selected module from the rail before the selected module can be removed, repaired or replaced. The whole process is then repeated to remount all the modules. This process can cause excessive wear on components that may engage the rail as well as take time. It is desirable, therefore, to have a module that can be removed and remounted to a rail without disturbing the other modules on the rail.

U.S. Patent No. 4,956,747 discloses modules having base portions with spring contacts extending from one side to the other of each base portion. The forces generated by the spring contacts as they are compressed by engagement with terminals in adjacent modules act in a direction parallel to the rail and in a direction to push the modules apart, thus requiring the use of interlocking housing portions or the like to assure the modules remain together. Additionally, as more modules are added, the amount of force builds up. It is desirable, therefore, to have terminals that interconnect adjacent modules in which the forces are "self-contained", that is do not act to push the modules apart and do not build up as the number of modules on the rail are increased.

U.S. Patent No. 5,719,241 discloses modules that can be mounted to the rail in a direction orthogonal to the rail. The modules use flat bar-like power bridging members and terminals having resilient spring arms for interconnecting adjacent modules.

EP-A-0877542 discloses a terminal according to the preamble of claim 1.

The present invention is directed to an electrical terminal usable in input/output modules mounted to rails that overcomes problems associated with the prior art. The terminal is suitable for use as both a power and/or a data terminal in such a module. For purposes of illustration, the terminal will be shown as a power terminal in an input/output module. It is to be understood that the terminal is not limited to use in such a module.

The electrical terminal for interconnecting electrical modules in a stacked arrangement includes a U-shaped body having first, second and third connecting portions. The body has a base and opposed legs extending to free ends adapted to be electrically connected to circuits of a circuit board and defining the first connecting portion. A blade contact extends outwardly from one of the legs intermediate the base and free end and in a direction substantially perpendicular to the first connecting portion. The blade contact defines the second connecting portion. A receptacle contact extends outwardly from at least one of the legs intermediate the base and free end and in a direction substantially perpendicular to the first connecting portion and opposite to that of the blade contact. The receptacle contact defines the third connecting portion. Upon disposing the terminal in a terminal receiving passageway of a module with the first connecting portion electrically engaged to a circuit board therein and the second and third connecting portions being proximate openings in the passageway on opposite sides of the module, the second and third connecting sections are available for being mated with complementary connecting portions of adjacent modules in a stacked arrangement.

In the embodiment shown, the receptacle contact is a pair of spring arms, with one arm extending from each of the legs of the U-shaped body. The leading end of the blade contact is offset from the leg such that the blade contact is in alignment with an axis extending between the spring arms such that the terminal is hermaphroditic.

The invention is also directed to an electrical module having at least one of the above terminals disposed therein.

An embodiment of the invention will now be described by way of example with reference to the accompanying drawings.

FIGURE 1 is an isometric partially exploded view of an electrical system using the modular connector assembly of the present invention and illustrating two complementary mating connectors for one of the modules.

FIGURE 2 is an isometric exploded view of one of the connector assembly modules of Figure 1.

FIGURE 3 is an isometric view of an electrical terminal used in the assembly of Figure 1.

FIGURE 4 is an isometric view illustrating the position of a plurality of the terminals in the assembly with the circuit board being removed for purposes of illustration.

FIGURE 5 is an isometric view of a fragmentary portion of the module illustrating the position of the power and data terminals along one side of the module.

FIGURE 6 is a view similar to that of Figure 5 illustrating the position of the power and data terminals along the other side of the module.

FIGURE 7 is an isometric view of two modules that are being electrically connected together in a stacked arrangement.

FIGURE 8 is a plan sectional view of a fragmentary portion of a plurality of connectors illustrating the mated power and data terminals.

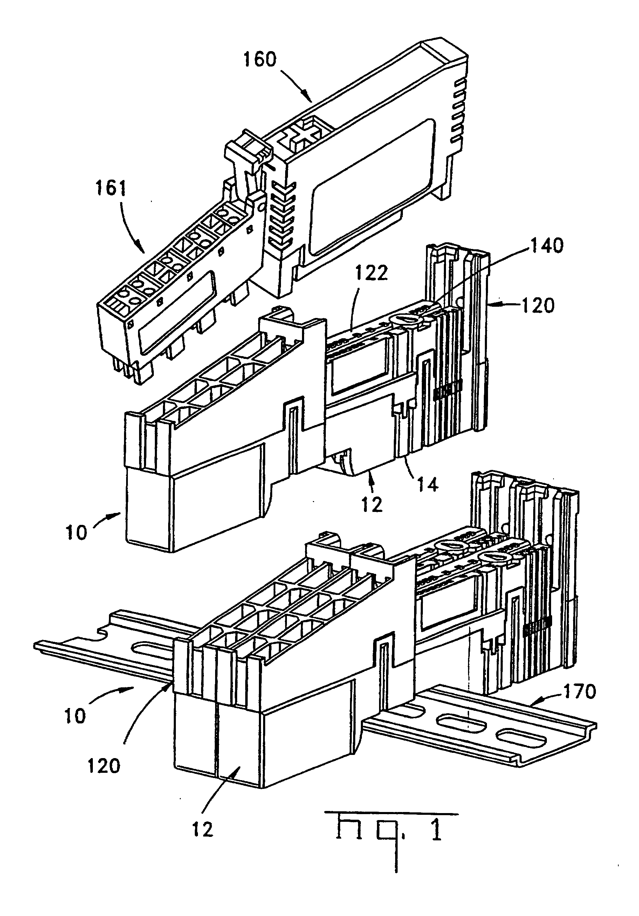

In Figure 1 two modules, each identified as a connector assembly 10 of the present invention, are shown mounted to a rail 170 of an electrical device. A third connector assembly 10 is shown exploded from the rail 170. Two complementary mating connectors 160, 161 are exploded from the third assembly 10.

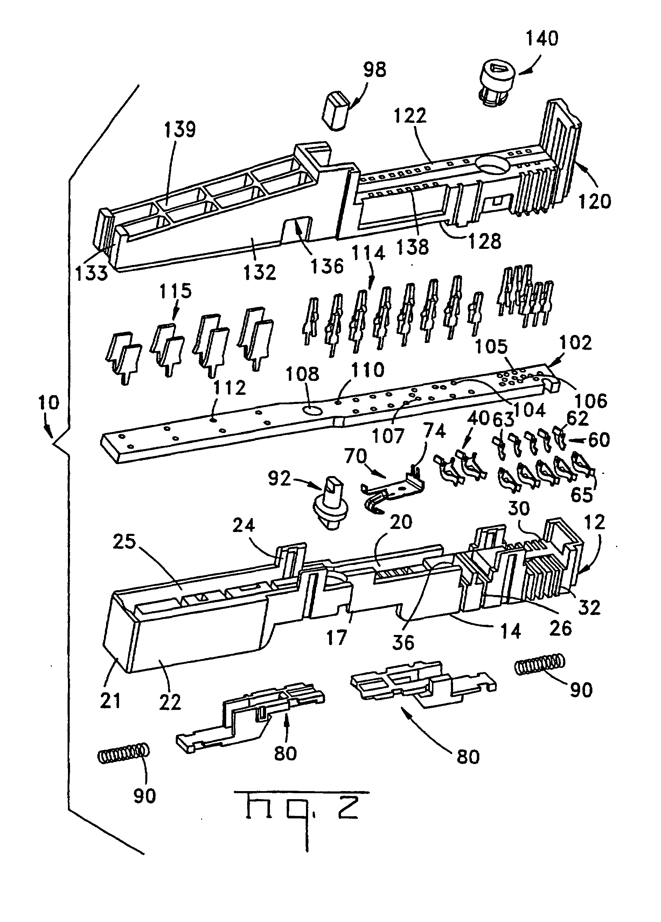

Referring now, to Figures 1 and 2, connector assembly 10 includes a lower housing 12 having a plurality of terminals 40, 60 and 70 disposed therein; an upper housing 120 securable to the lower housing 12 and having a plurality of terminals 114, 116 disposed therein and a circuit board 102 disposed between and within the housings 12, 120. Lower housing 12 has a rail mounting face 14 including a rail engaging recess 17, an assembly face 20, end walls 21, and side walls 22 having latch arms 24 extending upwardly therefrom and adapted to engage cooperating latch surfaces 136 on upper housing 120. End walls 21 and side walls 22 and assembly face 20 together define a circuit board receiving cavity 25 adapted to receive circuit board 102 therein. Housing 12 includes power terminal receiving passageways 26, data contact receiving cavities 30, 32 and ground terminal receiving cavity 36 for receiving respective power terminals 40, data terminal portions 62, 65, and ground terminal 70. Lower housing 12 further includes a pair of spring loaded rail engaging clamps 80 mounted to rail mounting face 14. Clamps 80 cooperate with springs 90 to hold connector assembly 10 on the rail 170, assembly 10 being released from the rail 170 by turning an actuator having lower portion 92 and upper portion 98. Further details about the operation of the rail engaging clamps are found in co-pending U. S. Patent Application Serial No. 60/129,178 (Attorney's Docket 17743L) filed concomitantly herewith.

Upper housing 120 has a mating face 122, an assembly face 128 and opposed side walls 132 having latch surfaces 136 adapted to receive latch arms 24 to hold the two housings 12, 120 together. Housing 120 further includes terminal receiving cavities 138 and 139 for receiving respective terminals 114 and 116 therein. Upper housing 120 further includes the upper portion 98 of the actuator and a programmable key-receiving member 140 that cooperates with a key protrusion (not shown) on mating housing 160. Further details about the operation of the key-receiving member are found in co-pending U. S. Patent Application Serial No. 60/129,158 (Attorney's Docket 17744L) filed concomitantly herewith.

As can best be seen in Figure 2, power terminals 40, data terminals 60 including blade sections 62 and compliant arm sections 65, and ground terminal 70 are adapted to be mounted to one side of circuit board 102 and terminals 114 and 116 are adapted to be mounted to the other side of circuit board 102. The terminals may be mounted using complaint sections or solder tails that are received in apertures of board 102 to be electrically connected to circuits of the board. It is to be understood that the terminals may also be surface mounted to board 102 by means known in the art. It is to be further understood that the connector may also include electronic components.

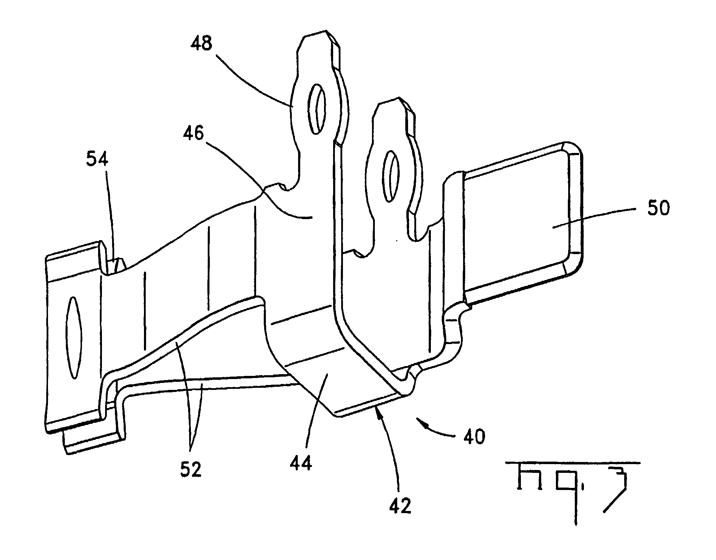

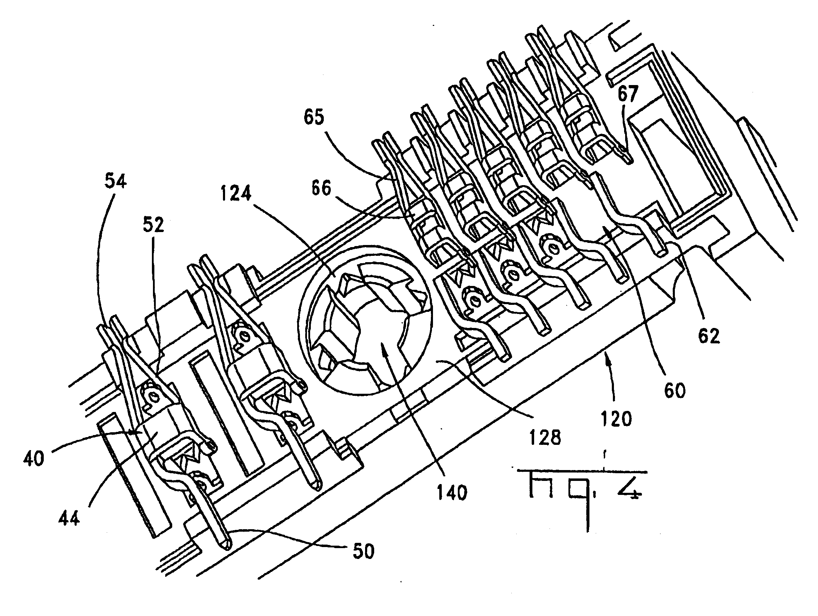

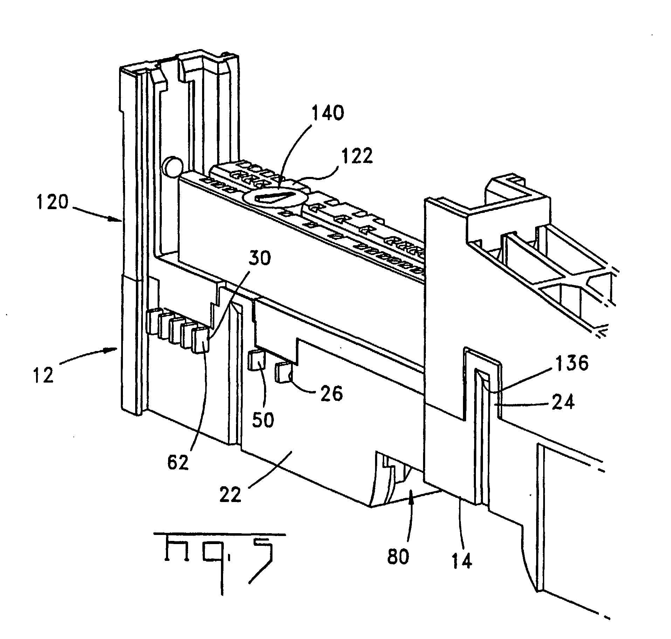

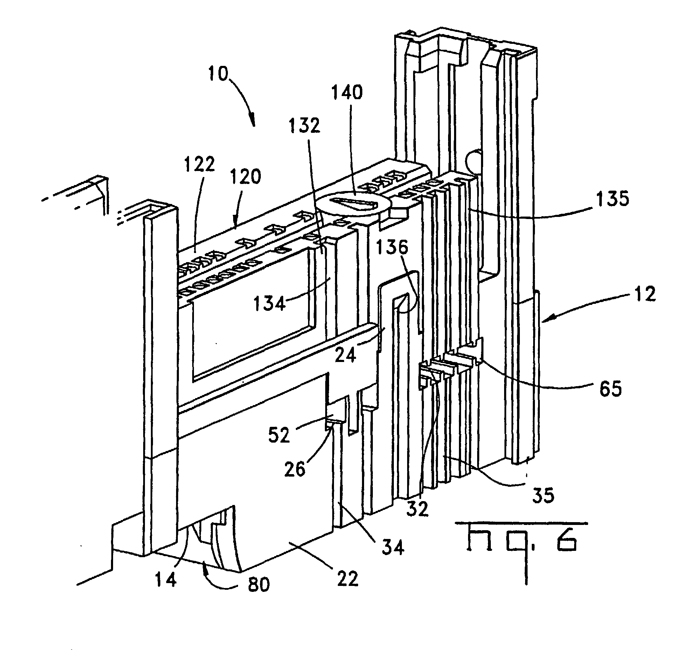

Referring now to Figures 3 through 6, each power or bus terminal 40 includes a U-shaped body 42 having a base 44 and opposed legs 46 extending to free ends 48 having compliant sections therein for electrically and mechanically engaging respective apertures 104 in circuit board 102, shown in Figure 2. Terminal 40 includes a blade contact 50 extending transversely outwardly in one direction from one of the legs 46 and a spring arm 52 extending transversely outwardly in the opposite direction from each leg 46 and defining a blade-receiving contact section 54 therebetween, as best seen in Figure 3. Figure 4 illustrates the position of the power terminals 40 with respect to assembly face 128 of upper housing 120. For purposes of clarity, circuit board 102 is not shown between terminals 40 and assembly face 128. This Figure also illustrates that blade 50 has been configured to be aligned with a center axis of terminal 40 that extends between spring arms 52 and legs 46 and along the leading end of blade 50. Terminal 40 is, therefore, hermaphroditic. Upon positioning power terminals 40 within their respective passageways 26, the blade contacts 50 extend outwardly from the side wall 22 and the leading ends of spring arms 52 are recessed within respective passageways 26, as best seen in Figures 5 and 6.

Data terminals 60 can be made substantially in the same manner as power terminals 40 with blade contact 62 and spring arms 65. In the embodiment shown, however, the data terminals 60 are formed as two separate sections with blade contacts 62 including a pair of compliant board mounting sections 63 (shown in Figure 2) and spring arms 62 extending from a U-shaped body 66 having compliant board mounting sections 67. The two sections are connected electrically through the circuit board 102. Upon positioning data terminals 60 within their respective cavities 30, 32, the blade contacts 62 extend outwardly from the side wall 22 and the leading ends of spring arms 65 are recessed from the wall surface, as seen in Figures 5 and 6. Data terminals 60 are also shown in Figure 4.

Referring again to Figure 2, one method of assembling connector assembly module 10 is to first dispose terminals 114 and 116 in respective cavities 138, 139 of upper housing 120. A circuit board subassembly can then be assembled by mounting the ground terminal 70, power terminals 40 and data terminals 60 in respective apertures 107, 104, 105 and 106 on the under side of circuit board 102. The upper side of the circuit board subassembly can then be disposed on the board mounting sections of terminals 114 and 116. The lower housing 12 having springs 90, rail engaging clamps 80 and lower actuator portion 92 disposed therein can then be secured to the upper housing and board subassembly. In the assembled connector lower actuator portion 92 extends through opening 108 of circuit board 102 and into the upper housing 120. Lastly, the upper actuator portion 98 and the key receiving member 140 are inserted into respective apertures in the upper housing 132.

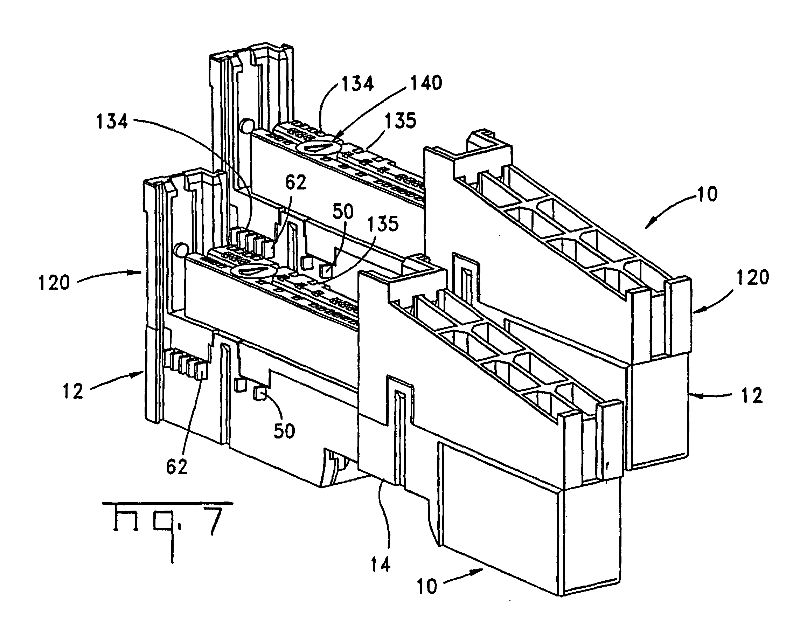

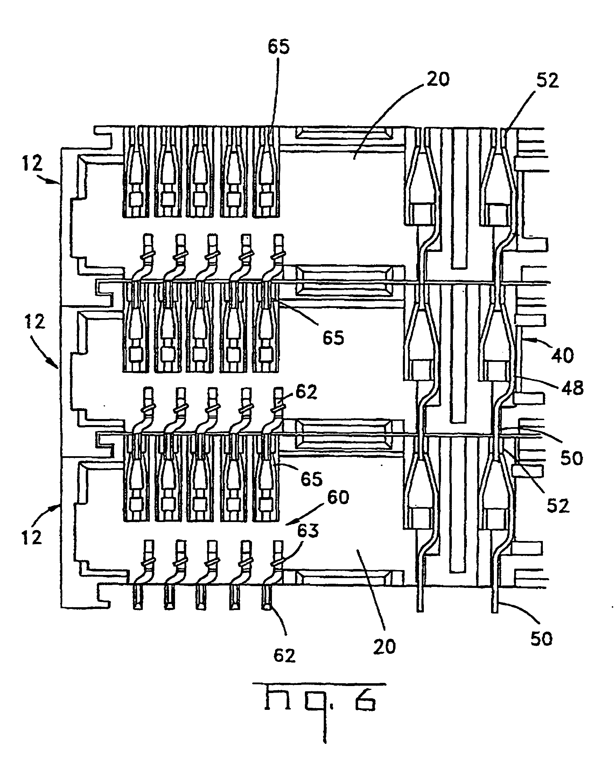

Figures 6 through 8 illustrate how adjacent connector assemblies 10 are stacked and the respective power and data terminals 40, 60 are mated to corresponding terminals of the adjacent module. Figure 6 shows that the leading ends of the respective spring arms 52, 65 are recessed from the surface of side wall 22 and are in communication with cooperating slots 35, 135 and 34, 134 in lower and upper housings 12, 120. As two modules 10 are brought into engagement, as shown in Figure 7, the respective blade contacts 50, 62 are aligned with slots 134, 135 in upper housing 120 and are moved into engagement between respective spring arm contact sections 54, 65 as the modules 10 are moved together in a vertical direction with respect to the rail 170, shown in Figure 1. Figure 8 illustrates a sectional view of the connector assembly 10 showing the terminals 40, 60 in lower housings 12 of three interconnected modules and the electrical engagement therebetween.

The present invention provides an electrical terminal that enables vertical assembly of the modules being stacked as well as enables easy replacement of designated modules. The terminal provides reliable electrical interconnection between the stacked modules. The forces generated by the mated spring arms and blades are "self contained" within the module. The forces are generated in a direction that is perpendicular to the longitudinal axis of the rail and, therefore, do not act to move the adjacent modules apart. Additionally the forces are generated perpendicular to the direction of mounting the modules to the rail and mating the corresponding contacts and, therefore, do not react to push the modules from the rail. The design of the terminal is suitable for carrying power and/or signals, the size of the terminal and the kind and thickness of metal stock being selected in accordance with the desired current carrying capability as known in the art. The terminal, furthermore, is hermaphroditic; thereby eliminating the need to manufacture different terminals for each side of the module. The terminal facilitates both adding and removing of modules from an electrical device, because the remaining modules can remain in place when one module is removed for repair or replacement.

It is thought that the electrical terminal of the present invention and many of its attendant advantages will be understood from the foregoing description. It is apparent that various changes may be made in the form, construction, and arrangement of parts thereof without departing from the scope of the claims.

## Claims

1. An electrical terminal (40) for interconnecting electrical modules (10) in a stacked arrangement, the terminal comprising:
a U-shaped body (42) having first (48), second (50) and third (52) connecting portions;
said body having a base (44) and opposed legs (46) extending to free ends (48), said free ends being adapted to be electrically connected to circuits of a circuit board and defining said first connecting portion;
a blade contact (50) extending in a direction substantially perpendicular to said first connecting portion and defining said second connecting portion; and
a receptacle contact (52) extending in a direction substantially perpendicular to said first connecting portion and opposite to that of said blade contact and defining said third connecting portion;
whereby upon disposing said terminal in a terminal receiving passageway of a said module with said first connecting portion electrically engaged to a circuit board associated with said module and said second and third connecting portions being proximate openings in said passageway on opposite sides of said module, said second and third connecting sections are available for being mated with complementary connecting portions of adjacent modules in a stacked arrangement, **characterised in that** said blade contact extends outwardly from one of said legs intermediate said base and free end and said receptacle contact extends outwardly from at least one of said legs intermediate said base and free end.

2. The electrical terminal of claim 1 wherein said receptacle contact is a pair of spring arms, one of said pair extending from each of said legs.

3. The electrical terminal of claim 2 wherein each spring arm includes an enlarged blade receiving portion at the leading end thereof.

4. The electrical terminal of claim 1 wherein said blade contact is offset a selected distance from the leg from which it extends such that the blade contact is in alignment with an axis extending through a center of said receptacle contact.

5. The electrical terminal of claim 4 wherein said receptacle contact is a pair of spring arms.

6. The electrical terminal of claim 5 wherein said terminal is hermaphroditic.

7. An electrical connector module adapted to be electrically connected to adjacent modules in a stacked arrangement comprising:
a housing having opposed first and second sides defining first and second module mating faces, and a plurality of terminal receiving passageways extending into said housing from and in communication with said first and second sides; and
a plurality of electrical terminals for interconnecting adjacent modules, each being disposed in a respective terminal receiving passageway, each said terminal including
a U-shaped body having first, second and third connecting portions, said body having a base and opposed legs extending to free ends, said free ends being adapted to be electrically connected to circuits of a circuit board and defining said first connecting portion;
a blade contact extending outwardly from one of said legs intermediate said base and free end and in a direction substantially perpendicular to said first connecting portion and defining said second connecting portion; and
a receptacle contact extending outwardly from at least one of said legs intermediate said base and free end and in a direction substantially perpendicular to said first connecting portion and opposite to that of said blade contact and defining said third connecting portion;
whereby upon disposing each said terminal in an associated terminal-receiving passageway of said module, electrically engaging said first connecting portion to a circuit board associated with said module and said second and third connecting portions of said terminals being proximate openings in said associated passageways on said first and second module mating surfaces, said second and third connecting sections are available for being mated with complementary connecting portions of terminals of adjacent modules in a stacked arrangement.

8. The electrical connector module of claim 7 wherein said receptacle contact is a pair of spring arms, one of said pair extending from each of said legs.

9. The electrical connector module of claim 8 wherein each spring arm includes an enlarged blade receiving portion at the leading end thereof.

10. The electrical connector module of claim 7 wherein said blade contact is offset a selected distance from the leg from which it extends such that the blade contact is in alignment with an axis extending through a center of said receptacle contact.

11. The electrical connector module of claim 10 wherein said receptacle contact is a pair of spring arms.

12. The electrical connector module of claim 11 wherein said terminal is hermaphroditic.

13. The electrical connector module of claim 7 wherein said blade contacts extend outwardly from said first module mating surface and said receptacle contacts are recessed from the second module mating surface.

14. The electrical connector module of claim 13 wherein said second module mating surface further includes a plurality of slots, each slot extending from said mating face of said housing and into communication with a respective one of said terminal receiving passageways such that an adjacent module may be connected by inserting the adjacent blade contacts into corresponding slots and moving the adjacent module in a vertical direction until the module and adjacent module are fully mated.

15. An electrical connector assembly comprising an electrical connector module of claim 7 wherein said associated circuit board is disposed on said first connecting portions with said board extending along said assembly face, said housing further including latching surfaces for securing a second connector housing thereto along said assembly face of said module.

16. The electrical connector assembly of claim 15 wherein said electrical connector module is adapted to be mounted to a rail in a stacked arrangement.

17. The electrical connector assembly of claim 15 wherein said blade contacts extend outwardly from said first module mating surface and said receptacle contacts are recessed from the second module mating surface.

18. The electrical connector assembly of claim 17 wherein said second module mating surface further includes a plurality of slots, each slot extending from said mating face of said housing and into communication with a respective one of said terminal receiving passageways such that an adjacent connector assembly may be connected by inserting the adjacent blade contacts into corresponding slots and moving the adjacent assembly in a vertical direction until the connector assembly and adjacent connector assembly are fully mated.

## Patentansprüche

1. Elektrisches Anschlußelement (40) zum Verbinden von elektrischen Modulen (10) miteinander in einer gestapelten Anordnung, wobei das Anschlußelement folgendes aufweist:
einen U-förmigen Körper (42), der einen ersten (48), einen zweiten (50) und einen dritten (52) Verbindungsbereich hat;
wobei der Körper eine Basis (44) und gegenüberliegende Schenkel (46) hat, die sich zu freien Enden (48) erstrecken, wobei die freien Enden so ausgebildet sind, daß sie mit Schaltkreisen einer Leiterplatte elektrisch verbunden werden, und den ersten Verbindungsbereich definieren;
einen Messerkontakt (50), der sich in einer Richtung erstreckt, die zu dem ersten Verbindungsbereich im wesentlichen senkrecht ist, und der den zweiten Verbindungsbereich definiert; und
einen Aufnahmekontakt (52), der sich in einer Richtung erstreckt, die zu dem ersten Verbindungsbereich im wesentlichen senkrecht und zu derjenigen des Messerkontakts entgegengesetzt ist, und der den dritten Verbindungsbereich definiert;
wobei beim Anordnen des Anschlußelements in einem Anschlußelementaufnahmekanal eines genannten Moduls, wobei der erste Verbindungsbereich mit einer dem Modul zugeordneten Leiterplatte in elektrischem Eingriff ist und der zweite und der dritte Verbindungsbereich in der Nähe von Öffnungen in dem Kanal an gegenüberliegenden Seiten des Moduls sind, der zweite und der dritte Verbindungsabschnitt zum Koppeln mit komplementären Verbindungsbereichen von benachbarten Modulen in einer gestapelten Anordnung verfügbar sind,
**dadurch gekennzeichnet, daß** sich der Messerkontakt von einem der Schenkel zwischen der Basis und dem freien Ende nach außen erstreckt und sich der Aufnahmekontakt von mindestens einem der Schenkel zwischen der Basis und dem freien Ende nach außen erstreckt.

2. Elektrisches Anschlußelement nach Anspruch 1, wobei der Aufnahmekontakt ein Paar von Federarmen ist, wobei sich einer von dem Paar von jedem der Schenkel erstreckt.

3. Elektrisches Anschlußelement nach Anspruch 2, wobei jeder Federarm einen vergrößerten Messeraufnahmebereich an dem Vorderende davon aufweist.

4. Elektrisches Anschtußelement nach Anspruch 1, wobei der Messerkontakt um eine ausgewählte Distanz von dem Schenkel versetzt ist, von dem er sich erstreckt, so daß der Messerkontakt mit einer Achse in Ausfluchtung ist, die sich durch einen Mittelpunkt des Aufnahmekontakts erstreckt.

5. Elektrisches Anschlußelement nach Anspruch 4, wobei der Aufnahmekontakt ein Paar von Federarmen ist.

6. Elektrisches Anschlußelement nach Anspruch 5, wobei das Anschlußelement hermaphroditisch ist.

7. Elektrisches Verbindermodul, das zur elektrischen Verbindung mit benachbarten Modulen in einer gestapelten Anordnung ausgebildet ist und folgendes aufweist:
ein Gehäuse, das folgendes hat: eine erste und eine zweite Seite, die einander gegenüberliegen und eine erste und eine zweite Modulkopplungsfläche definieren, und eine Vielzahl von Anschlußelementaufnahmekanälen, die sich von der ersten und der zweiten Seite und in Verbindung damit in das Gehäuse erstreckten; und
eine Vielzahl von elektrischen Anschlußelementen zum Verbinden von benachbarten Modulen miteinander, wobei jedes in einem entsprechenden Anschlußelementaufnahmekanal angeordnet ist, wobei jedes der genannten Anschlußelemente folgendes aufweist:
einen U-förmigen Körper, der einen ersten, einen zweiten und einen dritten Verbindungsbereich hat, wobei der Körper eine Basis und gegenüberliegende Schenkel hat, die sich zu freien Enden erstrecken, wobei die freien Enden so ausgebildet sind, daß sie mit Schaltkreisen einer Leiterplatte elektrisch verbunden werden, und den ersten Verbindungsbereich definieren;
einen Messerkontakt, der sich von einem der Schenkel zwischen der Basis und dem freien Ende nach außen und in eine Richtung erstreckt, die zu dem ersten Verbindungsbereich im wesentlichen senkrecht ist, und der den zweiten Verbindungsbereich definiert; und
einen Aufnahmekontakt, der sich von mindestens einem der Schenkel zwischen der Basis und dem freien Ende und in eine Richtung erstreckt, die zu dem ersten Verbindungsbereich im wesentlichen senkrecht und zu derjenigen des Messerkontakts entgegengesetzt ist, und der den dritten Verbindungsbereich definiert;
wobei beim Anordnen jedes der genannten Anschlußelemente in einem zugeordneten Anschlußelementaufnahmekanal des Moduls, wobei der erste Verbindungsbereich mit einer dem Modul zugeordneten Leiterplatte elektrisch in Eingriff ist und der zweite und der dritte Verbindungsbereich der Anschlußelemente in der Nähe von Öffnungen in den zugeordneten Kanälen an der ersten und der zweiten Modulkopplungsoberfläche ist, der zweite und der dritte Verbindungsabschnitt zum Koppeln mit komplementären Verbindungsbereichen von Anschlußelementen von benachbarten Modulen in einer gestapelten Anordnung verfügbar sind.

8. Elektrisches Verbindermodul nach Anspruch 7, wobei der Aufnahmekontakt ein Paar von Federarmen ist, wobei sich einer von dem Paar von jedem der Schenkel erstreckt.

9. Elektrisches Verbindermodul nach Anspruch 8, wobei jeder Federarm einen vergrößerten Messeraufnahmebereich an dem Vorderende davon aufweist.

10. Elektrisches Verbindermodul nach Anspruch 7, wobei der Messerkontakt um eine ausgewählte Distanz von dem Schenkel versetzt ist, von dem er sich erstreckt, so daß der Messerkontakt mit einer Achse in Ausfluchtung ist, die sich durch einen Mittelpunkt des Aufnahmekontakts erstreckt.

11. Elektrisches Verbindermodul nach Anspruch 10, wobei der Aufnahmekontakt ein Paar von Federarmen ist.

12. Elektrisches Verbindermodul nach Anspruch 11, wobei das Anschlußelement hermaphroditisch ist.

13. Elektrisches Verbindermodul nach Anspruch 7, wobei sich die Messerkontakte von der ersten Modulkopplungsoberfläche nach außen erstrecken und die Aufnahmekontakte von der zweiten Modulkopplungsoberfläche ausgespart sind.

14. Elektrisches Verbindermodul nach Anspruch 13, wobei die zweite Modulkopplungsoberfläche ferner eine Vielzahl von Schlitzen aufweist, wobei sich jeder Schlitz von der Kopplungsfläche des Gehäuses und in Verbindung mit einem entsprechenden der Anschlußelementaufnahmekanäle derart erstreckt, daß ein benachbartes Modul verbunden werden kann, indem die benachbarten Messerkontakte in entsprechende Schlitze eingesetzt und das benachbarte Modul in einer Vertikalrichtung bewegt wird, bis das Modul und das benachbarte Modul vollständig zusammengefügt sind.

15. Elektrische Verbinderanordnung, die ein elektrisches Verbindermodul nach Anspruch 7 aufweist, wobei die zugehörige Leiterplatte an den ersten Verbindungsbereichen angeordnet ist, wobei sich die Leiterplatte entlang der Anordnungsfläche erstreckt, wobei das Gehäuse ferner Arretieroberflächen zum Befestigen eines zweiten Verbindergehäuses daran entlang der Anordnungsfläche des Moduls aufweist.

16. Elektrische Verbinderanordnung nach Anspruch 15, wobei das elektrische Verbindermodul so ausgebildet ist, daß es an einer Schiene in einer gestapelten Anordnung angebracht wird.

17. Elektrische Verbinderanordnung nach Anspruch 15, wobei sich die Messerkontakte von der ersten Modulkopplungsoberfläche nach außen erstrecken und die Aufnahmekontakte von der zweiten Modulkopplungsoberfläche ausgespart sind.

18. Elektrische Verbinderanordnung nach Anspruch 17, wobei die zweite Modulkopplungsoberfläche ferner eine Vielzahl von Schlitzen aufweist, wobei sich jeder Schlitz von der Kopplungsfläche des Gehäuses und in Verbindung mit einem entsprechenden der Anschlußelementaufnahmekanäle derart erstreckt, daß eine benachbarte Verbinderanordnung verbunden werden kann, indem die benachbarten Messerkontakte in entsprechende Schlitze eingesetzt und die benachbarte Anordnung in einer Vertikalrichtung bewegt wird, bis die Verbinderanordnung und die benachbarte Verbinderanordnung vollständig zusammengefügt sind.

## Revendications

1. Borne électrique (40) pour interconnecter des modules électriques (10) dans un agencement empilé, la borne comportant :
un corps (42) en forme de U ayant des première (48), deuxième (50) et troisième (52) parties de connexion ;
ledit corps ayant une base (44) et des branches opposées (46) s'étendant jusqu'à des extrémités libres (48), lesdites extrémités libres étant conçues pour être connectées électriquement à des circuits d'une plaquette à circuits et définissant ladite première partie de connexion ;
un contact à lame (50) s'étendant dans une direction sensiblement perpendiculaire à ladite première partie de connexion et définissant ladite deuxième partie de connexion ; et
un contact femelle (52) s'étendant dans une direction sensiblement perpendiculaire à ladite première partie de connexion et opposée à celle de ladite lame de contact et définissant ladite troisième partie de connexion ;
grâce à quoi, en disposant ladite borne dans un passage de réception de bornes dudit module de façon que ladite première partie de connexion soit en prise électrique avec une plaquette à circuits associée audit module et que lesdites deuxième et troisième parties de connexion soient proches d'ouvertures dans ledit passage sur les côtés opposés dudit module, lesdites deuxième et troisième sections de connexion puissent être utilisées pour être accouplées avec des parties de connexion complémentaires de modules adjacents dans un agencement empilé, **caractérisée en ce que** ladite lame de contact fait saillie vers l'extérieur de l'une desdites branches entre ladite base et ladite extrémité libre, et ledit contact femelle fait saillie vers l'extérieur d'au moins l'une desdites branches entre ladite base et ladite extrémité libre.

2. Borne électrique selon la revendication 1, dans laquelle ledit contact femelle est constitué d'une paire de bras à ressort, l'un de ladite paire s'étendant depuis chacune desdites branches.

3. Borne électrique selon la revendication 2, dans laquelle chaque bras à ressort comprend à son extrémité avant une partie agrandie de réception d'une lame.

4. Borne électrique selon la revendication 1, dans laquelle ledit contact à lame est décalé d'une distance choisie de la branche de laquelle il fait saillie afin que le contact à lame soit en alignement avec un axe passant par le centre dudit contact femelle.

5. Borne électrique selon la revendication 4, dans laquelle ledit contact femelle est constitué d'une paire de bras à ressort.

6. Borne électrique selon la revendication 5, dans laquelle ladite borne est hermaphrodite.

7. Module à connecteur électrique conçu pour être connecté électriquement à des modules adjacents dans un agencement empilé, comportant :
un boîtier ayant des premier et second côtés opposés définissant des première et seconde phases d'accouplement de module, et une pluralité de passages de réception de bornes s'étendant dans ledit boîtier depuis lesdits premier et second côtés et communiquant avec eux ; et
une pluralité de bornes électriques destinées à interconnecter des modules adjacents, disposées chacune dans un passage respectif de réception de borne, chacune desdites bornes comprenant
un corps en forme de U ayant des première, deuxième et troisième parties de connexion, ledit corps ayant une base et des branches opposées s'étendant jusqu'à des extrémités libres, lesdites extrémités libres étant conçues pour être connectées électriquement à des circuits d'une plaquette à circuits et définissant ladite première partie de connexion ;
un contact à lame faisant saillie vers l'extérieur de l'une desdites branches entre ladite base et ladite extrémité libre et dans une direction sensiblement perpendiculaire à ladite première partie de connexion, et définissant ladite deuxième partie de connexion ; et
un contact femelle faisant saillie vers l'extérieur d'au moins l'une desdites branches entre ladite base et ladite extrémité libre et dans une direction sensiblement perpendiculaire à ladite première partie de connexion, et opposée à celle dudit contact à lame, et définissant ladite troisième partie de connexion ;
grâce à quoi, en disposant chacune desdites bornes dans un passage associé de réception de borne dudit module, mettant électriquement en prise ladite première partie de connexion avec une plaquette à circuits associée audit module, et lesdites deuxième et troisième partie de connexion desdites bornes étant proches d'ouvertures dans lesdits passages associés sur lesdites première et seconde surfaces d'accouplement du module, lesdites deuxième et troisième sections de connexion sont disponibles pour être accouplées avec des parties de connexion complémentaires de bornes de modules adjacents dans un agencement empilé.

8. Module à connecteur électrique selon la revendication 7, dans lequel ledit contact femelle se présente sous la forme d'une paire de bras à ressort, l'un de ladite paire s'étendant depuis chacune desdites branches.

9. Module à connecteur électrique selon la revendication 8, dans lequel chaque bras à ressort comprend une partie agrandie de réception de lame à son extrémité avant.

10. Module à connecteur électrique selon la revendication 7, dans lequel ledit contact à lame est décalé d'une distance choisie de la branche de laquelle il fait saillie afin que le contact à lame soit en alignement avec un axe passant par le centre dudit contact femelle.

11. Module à connecteur électrique selon la revendication 10, dans lequel ledit contact femelle se présente sous la forme d'une paire de bras à ressort.

12. Module à connecteur électrique selon la revendication 11, dans lequel ladite borne est hermaphrodite.

13. Module à connecteur électrique selon la revendication 7, dans lequel lesdits contacts à lames font saillie vers l'extérieur de ladite première surface d'accouplement du module et lesdits contacts femelles sont en retrait de la seconde surface d'accouplement du module.

14. Module à connecteur électrique selon la revendication 13, dans lequel ladite deuxième surface d'accouplement du module présente en outre plusieurs rainures, chaque rainure s'étendant depuis ladite surface d'accouplement dudit boîtier jusqu'en communication avec l'un respectif desdits passages de réception de borne afin qu'un module adjacent puisse être connecté par l'introduction des contacts à lames adjacents dans des rainures correspondantes et le déplacement du module adjacent dans une direction verticale jusqu'à ce que le module et le module adjacent soient totalement accouplés.

15. Assemblage de connecteurs électriques comportant un module à connecteur électrique selon la revendication 7, dans lequel la plaquette associée à circuits est disposée sur lesdites premières parties de connexion de façon que ladite plaquette s'étende le long de ladite face d'assemblage, ledit boîtier présentant en outre des surfaces de verrouillage pour fixer un second boîtier de connecteurs le long de ladite face d'assemblage dudit module.

16. Assemblage de connecteurs électriques selon la revendication 15, dans lequel ledit module à connecteur électrique est adapté pour être monté sur un rail dans un agencement empilé.

17. Assemblage de connecteurs électriques selon la revendication 15, dans lequel lesdits contacts à lames font saillie vers l'extérieur de ladite première surface d'accouplement du module et lesdits contacts femelle sont en retrait de ladite seconde surface d'accouplement du module.

18. Assemblage de connecteurs électriques selon la revendication 17, dans lequel ladite seconde surface d'accouplement du module présente en outre plusieurs rainures, chaque rainure s'étendant depuis ladite phase d'accouplement dudit boîtier jusqu'en communication avec l'un, respectif, desdits passages de réception de bornes de manière qu'un assemblage de connecteurs adjacents puisse être connecté par introduction des contacts à lames adjacents dans des rainures correspondantes et le déplacement de l'assemblage adjacent dans une direction verticale jusqu'à ce que l'assemblage de connecteur et l'assemblage de connecteur adjacent soient totalement accouplés.
